## Europäisches Patentamt

## European Patent Office

## Office européen des brevets

(19)

(11) Veröffentlichungsnummer: **0 210 541**
**B1**

(12) **EUROPÄISCHE PATENTSCHRIFT**

(45) Veröffentlichungstag der Patentschrift:
27.06.90

(21) Anmeldenummer: 86109741.8

(22) Anmeldetag: 16.07.86

(51) Int. Cl.⁵: **G03F 3/10**

(54) Farbprüffolie für das Overlay-Verfahren.

(30) Priorität: 25.07.85 US 758894

(43) Veröffentlichungstag der Anmeldung:
04.02.87 Patentblatt 87/6

(45) Bekanntmachung des Hinweises auf die Patenterteilung:
27.06.90 Patentblatt 90/26

(84) Benannte Vertragsstaaten:
DE GB

(56) Entgegenhaltungen:
EP-A- 0 188 228
US-A- 2 481 770
US-A- 3 356 523
US-A- 4 078 935
US-A- 4 333 983

JOURNAL FÜR
SIGNALAUFZEICHNUNGSMATERIALIEN, Band 9,
Nr. 5, 1981, Seiten 357-365, Akademie-Verlag, Berlin,
DD; M. SCHARF et al.: "Modellbetrachtungen zur
Vermeidung des Reflexionslichthofes von streuenden
und nichtstreuenden photographischen
Schichten" lladium(II)-Komplexen mit
Silbertetrafluoroborat zur Dimerisation von
Methylacrylat" 000

(73) Patentinhaber: HOECHST CELANESE CORPORATION,
Route 202-206 North, Somerville, N.J. 08876(US)

(72) Erfinder: Barton, O. Alfred, 49 Afton Drive, Florham Park
New Jersey 07932(US)

(74) Vertreter: Neubauer, Hans-Joachim et al, KALLE
Niederlassung der Hoechst AG Patentabteilung
Postfach 3540 Rheingaustrasse 190,
D-6200 Wiesbaden1(DE)

## Beschreibung

Die vorliegende Erfindung betrifft eine Overlay-Farbprüffolie mit einer Trägerfolie aus Polyester und einer gefärbten lichtempfindlichen Schicht. Beim Overlay-Farbprüfverfahren für den Mehrfarbendruck werden im allgemeinen Teilfarbenbilder in mindestens vier Farben angefertigt, so daß ein Satz Farbauszüge vor der Verwendung zur Herstellung von Mehrfarben-Druckplatten korrigiert und die später beim Drucken erhaltene Farbqualität beurteilt werden kann. Das Prüfbild muß ein getreues Abbild des gewünschten Druckbildes sein und soll den Tonwert der Farben weder erhöht noch herabgesetzt wiedergeben. Die visuelle Farbprüfung soll folgendes aufzeigen:

1. Fehler im Negativ,
2. die beste Farbwiedergabe, die beim Drucken in der Druckmaschine von dem Material zu erwarten ist,
3. die genaue Gradation aller Farbtöne und ob die Grautöne neutral sind,
4. die eventuelle Notwendigkeit zur Abschwächung einer der Farben und/oder Hinweise zur Änderung der Filmvorlagen vor der Herstellung der Druckplatten.

Bisher hat man zumeist Farbprüfungen für den Mehrfarbendruck mit einer Andruckmaschine vorgenommen, wobei alle auch beim tatsächlichen Mehrfarbendruck notwendigen Schritte unternommen werden müssen. Ein solches herkömmliches Verfahren ist jedoch kostspielig und zeitaufwendig.

Daneben werden auch photographische Verfahren angewendet. Das normale photographische Farbprüfverfahren ist das Overlay-Verfahren.

Beim Farbprüfen nach dem Overlay-Verfahren wird auf jeweils einem transparenten Kunststoffträger von jedem Farbauszug für sich ein Teilfarbenbild hergestellt, indem man eine lichtempfindliche Lösung in der entsprechenden Farbe aufbringt, diese trocknet und die erhaltene Schicht belichtet und die entwickelt. Zur Herstellung eines Farbprüfsatzes werden dann mehrere solcher mit Teilfarbenbildern versehener Träger übereinandergelegt. Das Overlay-Verfahren hat den Nachteil, daß die übereinanderliegenden Kunststoffträger durch ihre Lichtabsorption bzw.-reflexion dazu neigen, das Mehrfarbenbild grauer erscheinen zu lassen, so daß der Eindruck, den man von dem so angefertigten Farbprüfsatz erhält, sich sehr stark von den Drucken unterscheidet, die man mit einer Druck- bzw. Andruckmaschine erzielt. Der Hauptvorteil dieses Verfahrens besteht darin, daß es schnell ist und durch passergenaues Kombinieren von jeweils zwei oder drei Teilfarbenbildern zur Prüfung von Korrekturmaßnahmen dienen kann.

Wie eingangs erwähnt, besteht die für die Farbprüfung geeignete normale Farbprüffolie in ihrer einfachsten Form aus einer transparenten Trägerfolie, die einseitig mit einem einen Farbstoff enthaltenden lichtempfindlichen Gemisch beschichtet ist. Als lichtempfindliches Gemisch wird bei negativ arbeitenden Materialien allgemein eine Diazoniumverbindung allein oder in Kombination mit einem Harz als Bindemittel verwendet, und diese Masse wird durch Belichten mit aktinischer Strahlung gehärtet. Nach dem Entwickeln bleiben die vom Licht getroffenen Bereiche der durch eine Negativvorlage belichteten Beschichtung als Bild auf der Trägerfolie zurück.

Aufgabe der Erfindung war es, eine Farbprüffolie und ein Farbprüfverfahren vorzuschlagen, die Hintergrundbereiche mit geringerem Grauschleier ergeben.

Gegenstand der Erfindung ist eine Farbprüffolie mit einer transparenten Trägerfolie aus einem thermoplastischen Polyester aus einer Dicarbonsäure und einem Diol, einer transparenten Grundschicht und einer lichtempfindlichen Schicht, die ein polymeres wasserunlösliches, in wäßrig-alkalischen Lösungen lösliches Bindemittel, eine lichtempfindliche Substanz und einen Farbstoff oder ein Farbpigment enthält.

Die erfindungsgemäße Farbprüffolie ist dadurch gekennzeichnet, daß die Polyesterfolie eine erste transparente Grundschicht einer Dicke von 170 bis 340 nm aus aufgedampftem Aluminiumoxid und eine zweite transparente Grundschicht einer Dicke von 75 bis 125 nm aufgedampftem, vernetztem Magnesiumfluorid trägt.

Die lichtempfindliche Schicht enthält das polymere Bindemittel, eine lichtempfindliche Substanz und einen Farbstoff oder ein Farbpigment.

Erfindungsgemäß wird ferner ein Farbprüfverfahren vorgeschlagen, bei dem von einem Mehrfarbenbild Farbauszüge hergestellt, von den Farbauszügen Teilfarbenbilder in den Grundfarben des Mehrfarbendrucks durch Kopieren auf Farbprüffolien hergestellt und zur Gewinnung eines Mehrfarben-Prüfbilds passergenau übereinandergelegt werden.

Das erfindungsgemäße Verfahren ist dadurch gekennzeichnet, daß Farbprüffolien der vorstehend definierten Beschaffenheit eingesetzt werden.

Die erfindungsgemäße Farbprüffolie hat eine Polyesterträgerfolie mit wesentlich verbesserter Transparenz und Klarheit. Es wurde allgemein gefunden, daß eine geeignete reflexmindernde Beschichtung für Polyesterfolien transparent sein und einen Brechungsindex n haben soll, der geringer ist als der Brechungsindex der Polyesterfolie selbst (n ~ 1,6). Sehr vereinfacht kann man den Mechanismus, der zu diesem Phänomen führt, so erklären, daß das Licht, das normalerweise von einer Oberfläche der Folie zur anderen reflektiert würde, nun die Grenzfläche mit der geringeren Brechungsindexdifferenz ungehindert durchstrahlen kann und so zu dem Vorteil einer verbesserten Folientransparenz führt.

Als flexible Polyesterfolie kann jede beliebige flexible Folie genommen werden, die aus einem beliebigen thermoplastischen filmbildenden Polyester besteht, der durch Kondensation einer Dicarbonsäure oder eines niedermolekularen Dialkylesters dieser Säure mit einem Diol erhalten worden ist.

Von den filmbildenden Polyestern werden im Rahmen dieser Erfindung diejenigen bevorzugt, die zumindest einen größeren Anteil Polyethylenterephthalat enthalten, wobei Polyethylenterephthalatfolie insbesondere bevorzugt ist.

Die so hergestellte Folie kann eine Dicke von 12 bis 750 µm, vorzugsweise von 25 bis 220 µm, insbesondere von 75 bis 180 µm aufweisen.

Auf die Polyesterfolie wird eine im wesentlichen gleichmäßige, transparente Haftschicht aus Aluminiumoxid und darüber eine im wesentlichen gleichmäßige, transparente Schicht aus Magnesiumfluorid aufgebracht, wie sie in der US-A 4 333 983 beschrieben ist. Es hat sich gezeigt, daß die Schwierigkeit, eine ausreichende Haftung zwischen der Schicht aus Magnesiumfluorid und der Polyesterträgerfolie zu erreichen, durch die Aluminiumoxidschicht weitgehend ausgeräumt wird.

Das Aluminiumoxid wird nach bekannten Vakuumbedampfungsverfahren auf die Folienoberfläche aufgebracht. Dabei kann das Aluminiumoxid z. B. im Hochvakuum, vorzugsweise zwischen $10^{-3}$ und $10^{-5}$ Torr, auf eine Temperatur oberhalb seines Schmelzpunktes erhitzt werden, so daß sein Dampfdruck höher als $10^{-2}$ Torr liegt, oder das Aluminiumoxid kann einem Ionenbeschuß ausgesetzt werden, wobei es durch "Sputtern" abgetragen wird. Unter diesen Bedingungen wird das Aluminiumoxid zerstäubt bzw. "gesputtert" und emittiert in alle Richtungen Atome. Diese Atome treffen auf die Folienoberfläche auf, wo sie kondensieren und so die Aluminiumoxidschicht auf der Folie bilden.

Dadurch, daß die Aluminiumoxidhaftschicht einen Brechungsindex hat, der dem Brechungsindex der Polyesterträgerfolie nahezu entspricht (n von $Al_2O_3$ ~ 1,63), ist sie vom optischen Standpunkt im wesentlichen passiv. Das Aluminiumoxid wird in einer Dicke von mindestens 170 nm auf die Polyesterträgerfolie aufgebracht und soll eine Dicke von 340 nm nicht überschreiten. Besonders bevorzugt liegt die Dicke der Aluminiumoxidschicht relativ nahe bei 170 nm. Wie in der US-A 4 333 983 aufgezeigt, ist es wichtig, daß die Dicke der Aluminiumoxidhaftschicht einen Mindestwert hat, wenn die bestmögliche Haftung der Magnesiumfluoridschicht erreicht werden soll. Die maximale Dicke ist in erster Linie nur für die Erhaltung der größtmöglichen Klarheit der Folie von Bedeutung.

Die Magnesiumfluoridschicht (n ~ 1,38) dient als reflexmindernde Schicht und wird durch Vakuumbedampfen, wie oben beschrieben, in einer Dicke von etwa 75 bis 125 nm, bevorzugt um 100 bis 103 nm, auf die Aluminiumoxidschicht aufgebracht.

Die Magnesiumfluoridschicht wird nach dem Aufdampfen vernetzt, um zu verhindern, daß sie durch die beim Beschichten mit der lichtempfindlichen Schicht verwendeten Lösemittel oder beim Entwickeln eventuell abgelöst oder angegriffen wird. Das Vernetzen kann nach einem bekannten Verfahren erfolgen, z.B. durch Elektronenstrahlbehandlung.

Die mit der Magnesiumfluoridschicht versehene Polyesterfolie wird dann mit einem lichtempfindlichen Gemisch aus einem polymeren Bindemittel, einem Farbstoff oder Farbpigment und einer lichtempfindlichen Substanz beschichtet.

Für das erfindungsgemäße lichtempfindliche Gemisch sind alle für positiv und negativ arbeitende lichtempfindliche Gemische bekannten Komponenten geeignet. Negativ arbeitende, d.h. lichthärtbare Gemische werden gewöhnlich bevorzugt. Als Bindemittel kann eines der bekannten Bindemittel verwendet werden, das mit den anderen Komponenten verträglich ist und vorzugsweise einen Brechungsindex unter dem der Polyesterfolie aufweist.

Als Bindemittel für negativ arbeitende Systeme sind z.B. geeignet: Copolymere von Vinylchlorid mit Acryl- oder Methacrylsäure, Copolymere von Vinylacetat mit Acrylsäure, Methacrylsäure oder mit Maleinsäure oder Maleinsäureanhydrid; Copolymere von Styrol mit Maleinsäureanhydrid. In einem positiv arbeitenden System sind die als Bindemittel verwendeten Harze meistens Phenolharze, z.B. Phenol-Formaldehyd-Novolake. Das Bindemittel ist insbesondere ein Copolymeres von Methylmethacrylat und Methacrylsäure.

Zu den in der lichtempfindlichen Schicht enthaltenen Farbstoffen und Pigmenten zählen solche, deren Farbtöne im wesentlichen mit den Grundfarben des Mehrfarbendrucks übereinstimmen, z.B. Gelb, Blaugrün, Purpur und Schwarz. Geeignete Farbstoffe oder Pigmente sind beispielsweise Grasol Echtgelb 5 FL (C.I. Solvent Yellow 27), Grasol Echtrubin 2 BL (C.I. Solvent Red 128), Viktoriareinblau FGA (C.I. Basic Blue 81), Neozapongelb GG (C.I. Solvent Yellow 79), Neozaponechtrot BE (C.I. Solvent Red 122), Sudanblau II (C.I. Solvent Blue 35 -C.I. 6155 (S)), Victoria Cyan F6G (C.I. 42025), Rhodamin FB (C.I. 45170), Rhodamin 6 GDN Extra (C.I. 45160), Auraminkonzentrat (C.I. 41000), Ruß und ähnliche Farbmittel.

Als lichtempfindliche Substanzen können alle geeigneten bekannten lichtempfindlichen Diazoniumsalze verwendet werden. Bevorzugt werden die Diazoniumsalz-Polykon-Kondensationsprodukte, z. B. die mit Formaldehyd kondensierten Produkte, wie sie aus den US-A 2 063 631 und 2 667 415 bekannt sind und insbesondere die Mischkondensationsprodukte, die in den US-A 3 849 392, 3 867 147 und 4 436 804 beschrieben sind.

Das von diesen Diazoniumsalzen am meisten bevorzugte ist das in der US-A 3 849 392 beschriebene Kondensationsprodukt aus 3-Methoxy-diphenylamin-4-diazoniumsalz und 4,4'-Bis-methoxymethyldiphenylether.

Weitere als lichtempfindliche Substanzen gemäß dieser Erfindung geeignete Stoffe sind polymerisierbare Monomere oder Oligomere in Verbindung mit einem Photoinitiator, bei denen das für das Aufbringen auf die Folie verwendete Lösemittelsystem nicht so stark oder aggressiv ist, daß es die bereits auf der Folie befindliche nicht lichtempfindliche Grundschicht anlöst.

Es ist hervorzuheben, daß die erfindungsgemäß einsetzbaren lichtempfindlichen Massen bekannt sind und aufgrund ihrer Verträglichkeit und Eignung in Verbindung mit den hier beschriebenen Bindemitteln ausgewählt werden sollten.

Die lichtempfindlichen Beschichtungsgemische werden am bequemsten so auf die Trägerfolie aufgebracht, daß man eine Lösung oder Dispersion der Beschichtungsbestandteile in einem geeigneten Lösemittel herstellt, die gewünschte Menge der Lösung nach einem geeigneten Verfahren, z. B. durch Walzen-, Tauch-, Meniskus- oder Rakelbeschichtung oder durch Aufschleudern auf die Folienoberfläche aufbringt und das Lösemittel durch Trocknen aus der Beschichtung vertreibt, wobei allerdings ein gewisser Lösemittelrest zurückbleiben kann. Das lichtempfindliche Beschichtungsgemisch kann auf eine oder beide Seiten der beschichteten Polyesterträgerfolie aufgebracht werden, auch wenn die nicht lichtempfindliche erste Beschichtung sich nur auf einer Seite der Polyesterfolie befindet. Geeignete Lösemittel sind z. B. Dimethylsulfoxid, Dimethylformamid, Tetrahydrofuran, Glykolether, wie Propylenglykolmonomethylether, Ethylenglykolmonomethylether und Ethylenglykolmonoethylether; Ester, wie Ethylacetat, Butylacetat und Amylacetat; Ketone, wie Methylethylketon, Cyclohexanon und Diacetonalkohol sowie Gemische dieser Lösemittel.

Bezogen auf das Trockengewicht soll die lichtempfindliche Beschichtung im allgemeinen etwa 25 bis 75 Gew.-% Bindemittel enthalten. Ein wirksamer Farbstoffbzw. Pigmentanteil liegt allgemein im Bereich von 2 bis 15 Gew.-%, und die Anteile an lichtempfindlichen Substanzen entsprechen den üblichen Mengen. Der Feststoffanteil der Beschichtungslösung richtet sich nach dem angewendeten Beschichtungsverfahren, im allgemeinen sind jedoch Lösungen mit einem Feststoffgehalt von 2 bis 20 Gew.-% ausreichend.

Vorteilhaft hat die lichtempfindliche Beschichtung ein Schichtgewicht von 0,35 bis 2,5, vorzugsweise von 0,8 bis 1,5 g/m².

Die so hergestellte Overlay-Farbprüffolie kann durch eine geeignete Maske oder Kontaktvorlage mit aktinischem Licht belichtet und anschließend mit einem wäßrig-alkalischen Entwickler entwickelt werden. Geeignete Entwickler können als Komponenten z. B. Mononatriumphosphat, Trinatriumphosphat und das Natriumsalz des 7-Ethyl-2-methyl-4-undecanolsulfats enthalten.

Beispiel 1

Die Transparenzen einer erfindungsgemäß mit einer transparenten Grundschicht versehenen Folie, einer bekannten zur Verbesserung der Klarheit mit einer Haftvermittlerschicht versehenen Polyesterfolie (Melinex 505, Hersteller ICI), einer zur leichteren Handhabung und zur antistatischen Ausrüstung mit feinteiligem SiO₂ substrierten Polyesterfolie (Melinex 516, Hersteller ICI) und einer Celluloseacetatfolie (Hersteller Anitec) werden spektrophotometrisch ermittelt und miteinander verglichen. Dabei wird die Transparenz von 1 bis 4 Lagen der jeweiligen Folie gemessen. Die Ergebnisse sind in der folgenden Tabelle aufgeführt.

## Tabelle

| Anzahl der Lagen | erfindungs- gem. Folie | Melinex 505 | Melinex 516 | Cellulose- acetat |
|---|---|---|---|---|
| 1 | 0,005 | 0,049 | 0,057 | 0,033 |
| 2 | 0,019 | 0,100 | 0,114 | 0,073 |
| 3 | 0,033 | 0,152 | 0,172 | 0,114 |
| 4 | 0,048 | 0,203 | 0,225 | 0,155 |

Beispiel 2

Zur Herstellung eines lichtempfindlichen Gemischs werden 2,7 g eines Copolymeren aus 85 % Methylmethacrylat und 15 % Methacrylsäure (Bindemittel) in einem Lösemittelgemisch aus 43,7 g Methylethylketon und 43,7 g Propylenglykolmonomethylether unter mäßigem Rühren gelöst, wonach die folgenden Farbstoffe unter Rühren zugegeben werden: 0,037 g Victoria Cyan F6G und 0,714 g Viktoriareinblau FGA. Anschließend werden der Lösung unter ständigem Rühren zunächst 1,067 g des Kondensationsproduktes aus 3-Methoxy-diphenylamin-4-diazoniumsalz und 4,4'-Bis-methoxymethyldiphenylether, isoliert als Mesitylensulfonat, und dann 8,077 g Hydroxypropylcellulose (erhältlich unter der Bezeichnung Klucel MF von Hercules Corp.) als 1,5 %ige Lösung in Propylenglykolmonomethylether zugesetzt. Um ein vollständiges Durchmischen zu gewährleisten, wird der Ansatz nach Zugabe aller Komponenten noch 30 Minuten gerührt.

Mit einem Drahtrakel wird dieses Gemisch dann auf eine erfindungsgemäß vorbeschichtete Folie aufgebracht und 1 Minute bei 66° C getrocknet. Die beschichtete Folie wird anschließend unter einer Negativvorlage 20 Sekunden in einem Berkey-Ascor-Belichtungsgerät belichtet und mit einem wäßrig-alkalischen Entwickler aus Trinatriumphosphat, Mononatriumphosphat, dem Natriumsalz des 7-Ethyl-2-methyl-4-undecanolsulfats (erhältlich unter der Bezeichnung Niaproof 4 von Niacet Co.) und Wasser von Hand entwickelt. Die Bilder lassen sich ohne Anzeichen einer Schleierbildung und, wegen der hervorragenden Klarheit der Folie, mit sehr guter Bildschärfe entwickeln. An der entwickelten Folie wird eine Transparenz von 0,011 gemessen.

Beispiel 3

Ein lichtempfindliches Gemisch wird hergestellt, indem 2,7 g eines Copolymeren aus 85 % Methylmethacrylat und 15 % Methacrylsäure als Bindemittel in einem Lösemittelgemisch aus 41,5 g Methylethylketon und 41,5 g Propylenglykolmonomethylether unter mäßigem Rühren gelöst werden. Dann werden die folgenden Farbstoffe unter Rühren zugegeben: 0,4 g Calcozingelb SFW, 0,2 g Rhodamin 6 GDN und 0,1 g Viktoriareinblau FGA. Unter ständigem Rühren werden der Lösung nacheinander 1,7 g des Kondensationsproduktes aus 3-Methoxy-diphenylamin-4-diazoniumsalz und 4,4'-Bis-methoxymethyldiphenylether und 3,0 g Hydroxypropylcellulose (Klucel MF) als 1,5 %ige Lösung in Propylenglykolmonomethylether zugesetzt. Um ein vollständiges Durchmischen zu gewährleisten, wird der Ansatz nach Zugabe aller Komponenten noch 30 Minuten gerührt.

Mit einem Rakel wird das lichtempfindliche Gemisch dann auf eine erfindungsgemäß vorbeschichtete Folie aufgetragen und 1 Minute bei 66° C getrocknet. Die beschichtete Folie wird anschließend unter einer Negativvorlage 30 Sekunden in einem Berkey-Ascor-Belichtungsgerät belichtet und mit einem wäßrig-alkalischen Entwickler aus Trinatriumphosphat, Mononatriumphosphat, dem Natriumsalz des 7-Ethyl-2-methyl-4-undecanolsulfats (Niaproof 4) und Wasser von Hand entwickelt. Auch hier lassen sich die Bilder ohne Schleierbildung und mit sehr guter Bildschärfe entwickeln. An der entwickelten Folie wird eine Transparenz von 0,010 gemessen.

## Patentansprüche

1. Farbprüffolie mit einer transparenten Trägerfolie aus einem thermoplastischen Polyester aus einer Dicarbonsäure und einem Diol, einer transparenten Grundschicht und einer lichtempfindlichen Schicht, die ein polymeres wasserunlösliches, in wäßrig-alkalischen Lösungen lösliches Bindemittel, eine lichtempfindliche Substanz und einen Farbstoff oder ein Farbpigment enthält, dadurch gekennzeichnet, daß die Folie eine erste transparente Grundschicht einer Dicke von 170 bis 340 nm aus aufgedampftem Aluminiumoxid und eine zweite transparente Grundschicht einer Dicke von 75 bis 125 nm aus aufgedampftem, vernetztem Magnesiumfluorid trägt.

2. Farbprüffolie nach Anspruch 1, dadurch gekennzeichnet, daß die lichtempfindliche Schicht lichthärtbar ist.

3. Farbprüffolie nach Anspruch 2, dadurch gekennzeichnet, daß die lichtempfindliche Substanz ein Diazoniumsalz-Polykondensationsprodukt ist.

4. Farbprüffolie nach Anspruch 1, dadurch gekennzeichnet, daß sie auf beiden Seiten eine transparente Grundschicht trägt.

5. Farbprüfverfahren, bei dem von einem Mehrfarbenbild Farbauszüge hergestellt, von den Farbauszügen Teilfarbenbilder in den Grundfarben des Mehrfarbendrucks durch Kopieren auf Farbprüffolien hergestellt und zur Gewinnung eines Mehrfarben-Prüfbilds passergenau übereinandergelegt werden, dadurch gekennzeichnet, daß Farbprüffolien gemäß einem der Ansprüche 1 bis 4 eingesetzt werden.

## Claims

1. Colour test foil having a transparent backing foil consisting of a thermoplastic polyester made from a dicarboxylic acid and a diol, a transparent base layer and a photosensitive layer which contains a polymeric binder which is insoluble in water but soluble in aqueous-alkaline solutions, a photosensitive substance and a dye or a coloured pigment, characterized in that the foil carries a first transparent base layer with a thickness of from 170 to 340 nm consisting of vapour-deposited aluminium oxide, and a second transparent base layer with a thickness of 75 to 125 nm consisting of vapour-deposited, crosslinked magnesium fluoride.

2. Colour test foil according to Claim 1, characterized in that the photosensitive layer is photocurable.

3. Colour test foil according to Claim 2, characterized in that the photosensitive substance is a diazonium salt polycondensation product.

4. Colour test foil according to Claim 1, characterized in that it carries a transparent base layer on both sides.

5. Colour test method in which colour separations are produced from a colour image, partial colour images in the primary colours of the colour print are produced from the colour separations by copying onto colour test foils and are positioned accurately one on top of the other to give a colour test image, characterized in that colour test foils according to one of Claims 1 to 4 are employed.

## Revendications

1. Feuille d'épreuve en couleurs avec une feuille support transparente en un polyester thermoplastique obtenu à partir d'un acide dicarboxylique et d'un diol, une couche de base transparente et une couche photosensible, qui contient un agent liant polymère insoluble dans l'eau et soluble dans des solutions aqueuses alcalines, une substance photosensible et une substance colorante ou un pigment colorant, caractérisée en ce que la feuille comporte une première couche de base transparente d'une épaisseur de 170 à 340 nm en oxyde d'aluminium déposé par vaporisation et une deuxième couche de base transparente d'une épaisseur de 75 à 125 nm en fluorure de magnésium réticulé, déposé par vaporisation.

2. Feuille d'épreuve en couleurs selon la revendication 1, caractérisée en ce que la couche photosensible est photodurcissable.

3. Feuille d'épreuve en couleurs selon la revendication 2, caractérisée en ce que la substance photosensible est un produit de polycondensation d'un sel de diazonium.

4. Feuille d'épreuve en couleurs selon la revendication 1, caractérisée en ce qu'elle comporte sur les deux faces une couche de base transparente.

5. Procédé d'essai de couleurs dans lequel on prépare d'abord des sélections de couleurs à partir d'une image polychrome, puis on prépare des images trichromes dans les couleurs du fond de l'impression polychrome à partir des sélections de couleur par copie sur feuilles d'épreuve en couleurs et on les superpose de manière à les faire coïncider exactement pour obtenir une image d'épreuve polychrome, caractérisé en ce qu'on utilise comme feuilles d'épreuve en couleurs des feuilles selon l'une des revendications 1 à 4.